## Europäisches Patentamt

## European Patent Office

## Office européen des brevets

(19)

(11) Veröffentlichungsnummer: **0 068 416**

**B1**

(12) **EUROPÄISCHE PATENTSCHRIFT**

(45) Veröffentlichungstag der Patentschrift:
**08.06.88**

(51) Int. Cl.⁴: **H 01 L 33/00, H 01 L 21/208**

(21) Anmeldenummer: **82105471.5**

(22) Anmeldetag: **22.06.82**

(54) Lumineszenzdiode mit hohem Wirkungsgrad und hoher Grenzfrequenz der Modulierbarkeit.

(30) Priorität: **24.06.81 DE 3124817**

(43) Veröffentlichungstag der Anmeldung:
**05.01.83 Patentblatt 83/1**

(45) Bekanntmachung des Hinweises auf die Patenterteilung:
**08.06.88 Patentblatt 88/23**

(84) Benannte Vertragsstaaten:
**AT BE CH FR GB IT LI NL SE**

(56) Entgegenhaltungen:
**DE-A-2 527 074**
**US-A-4 199 385**
**US-A-4 268 327**

**JOURNAL OF APPLIED PHYSICS, Band 48, Nr. 6, Juni 1977, Seiten 2485-2492, American Institute of Physics, New York, US; L.R. DAWSON: "High-efficiency graded-band-gap Ga1-xAlxAs light-emitting diodes"**
**PATENTS ABSTRACTS OF JAPAN, Band 6, Nr. 164 (E-127) 1042 , August 1982, Tokyo, JP; & JP - A - 57 83 072 (HANDOUTAI KENKIYUU SHINOUKAI) 24.05.1982**

(73) Patentinhaber: **Siemens Aktiengesellschaft Berlin und München, Wittelsbacherplatz 2, D-8000 München 2 (DE)**

(72) Erfinder: **Leibenzeder, Siegfried, Strassbergstrasse 19, D-8520 Erlangen (DE)**
Erfinder: **Weyrich, Claus, Dr.phil., Untertaxetweg 14, D-8035 Gauting b. München (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

## Beschreibung

Die vorliegende Erfindung bezieht sich auf eine Lumineszenzdiode, wie sie in Oberbegriff des Patentanspruchs 1 angegeben ist.

Seit mehr als einem halben Jahrzehnt gibt es Lumineszenzdioden aus Gallium-Aluminium-Arsenid, in deren Mischkristall-Epitaxieschicht dieser Zusammensetzung die schichtweise örtliche Konzentration des Aluminium-Anteils, der einen entsprechenden Gallium-Anteil ersetzt, mit stetigem Gradienten unterschiedlich ist. Ein solcher Aufbau der Mischkristall-Schicht wird in der Fachwelt als "graded-bandgap" bezeichnet. Eine solche Anordnung hat einen Bandabstand, der dem sich ständig ändernden Aluminium-Gehalt entsprechend stetig verschieden groß ist und den größten Bandabstand bei maximalem Aluminium-Gehalt hat. Zweck eines solchen Mischkristalls ist es, in einem schichtförmigen Bereich mit wenigstens nahezu konstantem Aluminium-Gehalt erzeugte Rekombinations-Lumineszenzstrahlung in der Weise aus der gesamten Mischkristall-Schicht austreten lassen zu können, daß diese Strahlung nur noch solche Volumenbereiche der Schicht zu durchdringen hat, in der (wegen dort größeren Aluminium-Gehaltes) der Bandabstand größer ist. Damit ist Reabsorption erzeugten Lumineszenzstrahlung insoweit verhindert.

Der in der Mischkristall-Schicht einer solchen Lumineszenzdiode mit "graded-bandgap" enthaltene pn-Übergang, der flächenmäßig senkrecht zum Vektor des Gradienten des Alumium-Gehaltes ausgedehnt ist, ist bei diesen schon lange bekannten Lumineszenzdioden durch Silizium-Dotierung erzeugt. Das Silizium hat in einem solchen Mischkristall amphoteren Dotierungscharakter, nämlich abhängig von der Abscheidetemperatur.

Weitere Einzelheiten einer solchen bekannten Diode können aus "Siemens Forschungs- und Entwicklungsberichte", Bd. 9 (1980), Nr. 6, Seiten 339-346 entnommen werden. In dieser zum Stand der Technik gehörenden Druckschrift ist nicht nur eine solche bekannte Lumineszenzdiode beschrieben, sondern es sind auch die einschlägigen Verfahrensmaßnahmen zur Herstellung, die Eigenschaften einer solchen Diode und auch deren bevorzugte Anwendung ins einzelne gehend beschrieben.

Bekannt ist aus DE-A-2 527 074 eine Gallium-Aluminium-Arsenid-Diode mit einem Substratkörper, in dem zwei Bereiche mit unterschiedlichem Aluminiumgehalt vorhanden sind. Der eine Bereich mit einem x-Anteil an Aluminium ist p-dotiert und der zweite Bereich mit dem davon verschiedenen y-Aluminiumgehalt ist n-dotiert. Mit dem dort beschriebenen Herstellungsverfahren soll es möglich sein, daß die bisher unter Verwendung einer Maske aus dielektrischem Material durchgeführte Zink-Dotierung entbehrlich wird. Es ist dort vorgesehen, von einem p+-Gallium-Arsenid-Substrat auszugehen und nacheinander erst eine p-dotierte Schicht mit konstantem x-Aluminium-Anteil und dann eine n-dotierte Schicht mit nach Zugabe von Aluminium höherem y-Aluminium-Anteil von Gallium-Aluminium-Arsenid epitaktisch abzuscheiden. Es wird dort eine Maske auf der n-dotierten Schicht verwendet und die p-Dotierung wird durch Ionenimplantation mit nachfolgendem Diffusionstempern vorgenommen.

Aus den in ihrem sachlichen Inhalt im wesentlichen übereinstimmenden Druckschriften "Appl. Phys. Letters", Bd. 19 (1971), S. 98 - 100 und "IEEE Transactions on Electron Devices" ED 21 (1974), S. 688 - 691, ist eine Lumineszenzdiode bekannt, deren Halbleiterkörper epitaktisch hergestellt ist und der aus Gallium-Aluminium-Arsenid mit sich entsprechend einem Gradienten ändernden Aluminiumgehalt besteht. Dieser Körper ist durch und durch n-leitend dotiert. Der für die Diode erforderliche pn-Übergang wird durch erst nachträgliches Einbringen von p-Dotierung erzeugt. Um diese p-Dotierung tatsächlich in dem für eine vorgegebene Wellenlänge relevanten Bereich des Gallium-Aluminium-Arsenid-Körpers durchführen zu können, wird dort der zuvor hergestellte n-Gallium-Aluminium-Arsenid-Körper von der Seite des geringeren Aluminiumgehaltes her so weit abgeläppt, bis die Lage mit dem gewünschten Aluminiumgehalt erreicht ist. Die Eindringtiefe der p-dotierenden Zink-Diffusion wird dort dadurch noch vergrößert, daß zunächst Zink in großem Überschuß eindiffundiert und dann mit Hilfe einer Wärmebehandlung die örtliche Zink-Konzentration wieder herabgesetzt wird. Da aber der p-dotierte Anteil des Gallium-Aluminium-Arsenid-Körpers der Diode der die mechanische Stabilität gewährleistende Anteil ist, muß dann noch nach diesen Verfahrensschritten in einem dritten Epitaxieschritt weiteres p-leitendes Gallium-Aluminium-Arsenid mit entsprechend niedrigem Al-Gehalt wieder neu abgeschieden werden.

Lumineszenzdioden mit "graded-bandgap" haben eine relativ große Halbwertsbreite ihres Emission-Spektrums.

Zusätzlich zu den Lumineszenzdioden des voranstehend beschriebenen Typs gibt es weitere Arten von Lumineszenzdioden, so z. B. Lumineszenzdioden mit Einfach-Heterostruktur. Solche Dioden sind in der Weise hergestellt, daß sie mindestens zwei Epitaxie-Schichten enthalten, die in zwei getrennten Epitaxie-Schritten hergestellt sind.

Aufgabe der vorliegenden Erfindung ist es, eine Lumineszenzdiode herzustellen, die für ihren jeweiligen Emissions(Frequenz-)bereich, vorzugsweise im Infrarot-Bereich und/oder im sichtbaren Bereich, einen hohen elektrooptischen Wirkungsgrad hat und/oder die eine hohe Grenzfrequenz, insbesondere von wenigstens 5 MHz, für ihre Modulierbarkeit hat und die mit geringem technischen und technologischen Aufwand und geringem Ausschuß herstellbar ist.

Diese Aufgabe wird mit dem Verfahren nach dem Oberbegriff des Patentanspruchs 1 mit den Merkmalen des Kennzeichens dieses Anspruchs 1 gelöst. Eine Weiterbildungen der Erfindung geht aus den Unteranspruch hervor.

Der Idee der vorliegenden Erfindung liegt die Überlegung zugrunde, daß preiswert und mit nur geringem Ausschuß herzustellende Lumineszenzdioden nur nach solchen Verfahren zu erhalten sind, bei denen nur ein einziger Epitaxie-Schritt notwendig ist. Zum einen ist nämlich mehrfache Epitaxie, wie bei Heterostrukturen, nicht nur aufwendig, sondern führt auch zu Verunreinigungsmängeln dadurch, daß beim Wechsel vom einen Expitaxie-Vorgang zum folgenden Epitaxie-Vorgang die Zwischenfläche im Gasraum freiliegt. Weiter liegt der Erfindung die Erkenntnis zugrunde, daß man, um weitverbreitete technische Anwendung einer neuen Lumineszenzdiode zu erreichen, die große Halbwertsbreite der seit langem bekannten, mit Silizium dotierten Lumineszenzdiode mit "graded-bangap" verringern muß. Es wurde festgestellt, daß die große Halbwertsbreite der bekannten Lumineszenzdiode auf einer zu großen Ausdehnung des pn-Übergans in der Mischkristall-Schicht zurückzuführen ist. Durch Versuche konnte nun nachgewiesen werden, daß durch eine andere Art der Dotierung erheblich geringere Halbwertsbreiten erreicht werden können, und zwar für unterschiedliche Wellenlängenwerte des Maximums der jeweiligen Emissionskurven. Darüber hinaus wurde aber auch noch eine ganz wesentliche weitere Erkenntnis gewonnen, nämlich daß solche nach dem erfindungsgemäßen Prinzip dotierten Lumineszenzdioden mit "graded-bandgap" insbesondere im kurzwelligeren Infrarot-Bereich und bis in den sichtbaren Rotbereich der Emission hinein derart hohen elektrooptischen Wirkungsgrad haben, daß sie darin nicht nur bekannte Lumineszenzdioden mit "graded-bandgap", sondern auch solche Lumineszenzdioden übertreffen, die nach wesentlich aufwendigeren Herstellungsverfahren erzeugt sind. Für viele technische Anwendungsfälle bringt die Erfindung außerdem noch den weiteren Vorteil, daß nach dem Prinzip der Erfindung aufgebaute Lumineszenzdioden eine obere Grenzfrequenz für die Modulation haben, die im MHz-Bereich liegt und Modulationsbandbreiten bis 5 MHz, d.h. bis zur Video-Bandbreite, gestattet.

Bei der Erfindung ist der Anteil der Mischkristall-Epitaxieschicht, der n-Leitung haben muß, mit Schwefel oder Selen oder vorzugsweise mit Tellur dotiert. Diese Elemente sind beim Herstellungsverfahren einer erfindungsgemäßen Lumineszenzdiode bereits in der im Epitaxie-Verfahren zur Herstellung der Schicht verwendeten Schmelze aus $A_{1-x}^{III}Al_xB^V$ enthalten. Der Schichtaufbau dieser n-leitenden Dotierung wird bis zu dem Zeitpunkt fortgesetzt, zu dem eine Mischkristall-Zusammensetzung mit einem solchen Aluminium-Gehalt epitaxial abgeschieden wird, der zu demjenigen Bandabstand führt, der dem geforderten Emissions-Wellenlängenmaximum des spektralen Emissionsbereichs der Diode entspricht. In diesem Zeitpunkt wird der Schmelze, aus der die Epitaxie-Schicht weiter fortlaufend abgeschieden wird, Zink zugegeben. Dieses Element Zink kann über die Gasphase oder auch als Feststoff zugefügt werden. Die Dotierungswirkung des Zinks ist derart, daß die n-leitende Dotierung des weiterhin noch, in der Schmelze enthaltenen Dotierungsmittels soweit überkommensiert wird, daß nunmehr Schichtanteile mit p-Leitung entstehen.

Bevorzugt wird für Lumineszenzdioden Gallium-Aluminium-Arsenid als Zusammensetzung der Mischkristall-Epitaxieschicht verwendet. Besonders vorteilhaft ist die Anwendung der Flüssigphasen-Epitaxie. Bezüglich der angegebenen Dotierungen ist die Kombination von Tellur mit Zink bevorzugt, und vorteilhaft ist es, das Zink aus der Gasphase zuzugeben.

Weitere Erläuterungen der Erfindung gehen aus der nachfolgenden Beschreibung zu den Figuren hervor.

Fig. 1 zeigt eine mit dem erfindungsgemäßen Verfahren hergestellte Diode.

Fig. 2 zeigt ein Diagramm des Verteilungskoeffizienten für Aluminium.

Fig. 3 zeigt ein Diagramm des Wirkungsgrades.

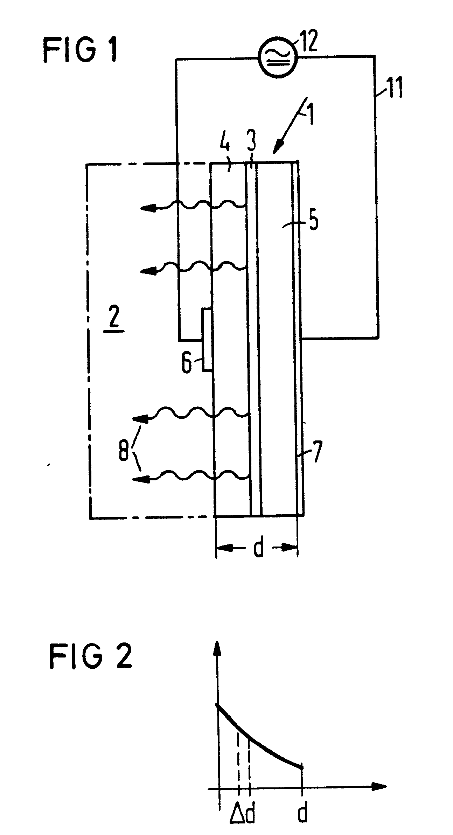

Mit 1 ist in Fig. 1 eine durch Epitaxie hergestellte Mischkristall-Schicht aus beispieisweise Gallium-Aluminium-Arsenid bezeichnet, deren Dicke d übertrieben groß wiedergegeben ist. Tatsächliche Schichtdicken fertiger Lumineszenzdioden nach der Erfindung liegen in der Größe von 150 bis 200 μm. Die epitaxiale Abscheidung der Mischkristall-Schicht 1 erfolgt auf einem gestrichelt wiedergebenen Substratkörper aus beispielsweise Galliumarsenid. Bereits im Herstellungsverfahren einer erfindungsgemäßen Lumineszenzdiode wird dieser Substratkörper 2 wieder entfernt, da er die Strahlungsemission behindert.

Fig. 2 zeigt aufgetragen über der Dicke d der Mischkristall-Schicht 1 auf der Ordinate den x-Gehalt an Aluminium in der jeweiligen Schichtebene Δd.

Mit 3 ist auf die wichtige Schichtebene des pn-Übergangs hingewiesen, der sich zwischen dem n-leitenden Schichtanteil 4 und dem p-leitenden Schichtanteil 5 der gesamten Mischkristall-Schicht befindet. Mit 6 und 7 ist auf Elektroden zur Stromzuführung durch die Mischkristall-Schicht 1 hingewiesen. Zumindest die Elektrode 6 ist als Punkt-, Ring- oder Streifenkontakt ausgebildet, an dem vorbei die Strahlung austritt.

Die in der pn-Übergangsschicht 3 erzeugte elektrolumineszente Rekombinationsstrahlung 8 kann diesen Übergang 3 ohne wesentliche Absorption durch den Schichtanteil hindurch verlassen, da dieser Schichtanteil 4 infolge des - vergleichsweise zum Schichtanteil des pn-Übergangs 3 - höheren Aluminium-Gehaltes größeren Bandabstand hat.

Mit 11 ist insgesamt auf den Stromkreis zwischen den äußeren Anschlüssen der Elektroden 6 und 7 hingewiesen, in dem sich eine insbesondere modulierbare Stromquelle 12 befindet.

Das Material der Mischkristall-Schicht 1 ist vorzugsweise Gallium-Aluminium-Arsenid. Der während des epitaxialen-Aufwachsens der Mischkristall-Schicht 1 auf dem Substratkörper 2 entstehende statig, Abfall der Konzentration des Aluminium-Gehaltes in der Schicht 1 beruht bekanntermaßen auf dem hohen Verteilungkoeffizienten des Aluminiums in der Gallium-Arsen-Schmelze. Vergleichsweise zu einer bekannten Si-dotierten Gallium-Aluminium-Arsenid-Infrarot-Lumineszenzdiode hat eine erfindungsgemäße Diode eine wenigstens nur halbmal so große Halbwertsbreite der spektralen Emissionsverteilung. Die schmalbandigere Emissionsstrahlung der erfindungsgemäßen Diode kann daher weit besser optisch von der Strahlung solcher weiteren Lumineszenzdioden anderen Typs unterschieden werden, die beispielsweise in ein und derselben Anordnung zusammen mit erfindungsgemäßen Lumineszenzdioden verwendet werden. Es lassen sich in einfacher Weise mit erfindungsgemäßen Lumineszenzdioden auf mehreren optischen Frequenzen arbeitende Mehr-Kanal-Geräte konzipieren, z. B. zu Ultrarot-Fernbedienung von Fernsehgeräten mit Fernseh-Kanalwahl, mit zusätzlicher Lautstärke-Regelung, mit zusätzlicher Bildhelligkeits- und/oder Kontrast-Regelung, und so weiter.

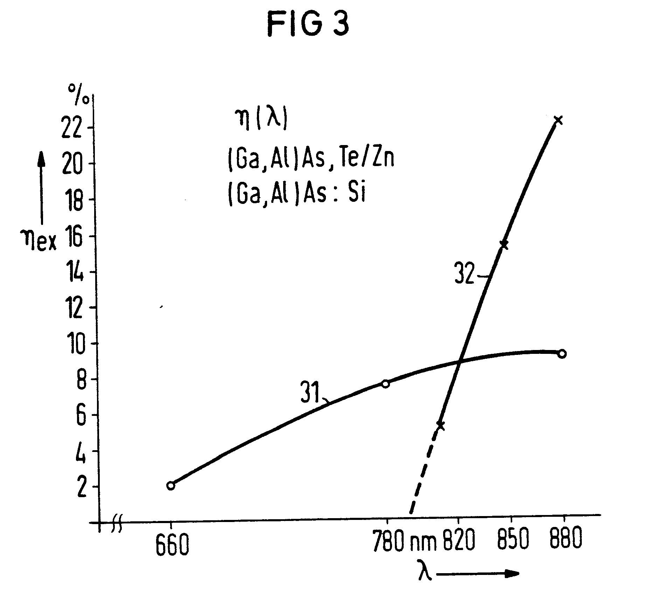

Insbesondere für batteriebetriebene Fernsteuerungs-Geräte ist der hohe elektrooptische Wirkungsgrad erfindungsgemäßer Lumineszenzdioden von Bedeutung. Fig. 3 zeit mit Kurve 31 einen Vergleich zum optischen Wirkungsgrad 32 einer bekannten Si-dotierten Diode. Auf der Abszisse ist die Wellenlänge der emittierten Strahlung und auf der Ordinate ist der Wirkungsgrad aufgetragen. Auffallend ist der bis in den sichtbaren Botbereich hohe elektrooptische Wirkungsgrad.

Eine erfindungsgemäß hergestellte Gallium-Aluminium-Arsenid-Lumineszenzdiode mit Tellur- und Zink-Dotierung hat eine Modulierbarkeit mit einer Abklingzeit der Lumineszenz, die bei höchstens 50 ns und vorzugsweise bei 10 bis 20 ns liegt. Eine solche erfindungsgemäße Diode läßt sich sogar zur Video-Band-Signalübertragung im Zusammenhang mit solchen Geräten verwenden, die für Fernsehspiele vorgesehen sind. Für eine erfindungsgemäße Lumineszenzdiode bzw. für deren Herstellung ist es wichtig, daß der Gradient der Aluminium-Verteilung in der Mischkristall-Schicht 1 (vergleichsweise zur bekannten Diode nach dem Oberbegriff) zumindest im Bereich des vorgesehenen pn-Übergangs steil ist. Damit läßt sich nachteilige Absorption verhindert, die vergleichsweise zu einer bekannten Diode bei der Erfindung relativ groß sein könnte, da die Emission der erfindungsgemäßen Diode näher der Bandkante erfolgt, als dies für eine mit Silizium dotiertan Diode gilt. Höhere Steilheit des Gradienten des Aluminium-Gehaltes kann durch höheren Aluminium-Gehalt in der Epitaxie-Ausgangsschmelze und/oder durch raschere Abkühlung der Schmelze während des Epitaxie-Prozesses erreicht werden.

### Patentansprüche

1. Verfahren zur Herstellung einer Lumineszenzdiode mit einem mit Elektroden versehenen Halbleiterkörper aus dotiertem, bereichsweise n-leitendem und bereichsweise p-leitendem Gallium-Aluminium-Arsenid, wobei in dem Halbleiterkörper ein stetiger Gradient der Konzentration des Aluminiumgehalts vorliegt und dieser Halbleiterkörper mit Hilfe der Flüssigphasenepitaxie auf zunächst einem Substratkörper abgeschieden worden ist, der in einer Endstufe des Herstellungsverfahrens wieder entfernt wird, <u>gekennzeichnet</u> dadurch, daß für eine vorgebbare Frequenz der Lumineszenzstrahlung der Diode,

- daß die Abscheidung eines ersten n-leitenden Bereichs (4) des Halbleiterkörpers (1) aus einer Tellur-, Schwefel- oder Selendotierten, das abzuscheidende Gallium-Aluminium-Arsenid enthaltenden Schmelze vorgenommen wird,

- daß unter weiter fortlaufender Abscheidung des Gallium-Aluminium-Arsenids bei Erreichen einer $Ga_{1-x}Al_xAs$ Mischkristall-Zusammensetzung mit einem Al-Gehalt x die den der vorgegebenen Lumineszenzfrequenz entsprechenden Bandabstand hat, Zink als neuer Dotierstoff der Schmelze in das bereits in der Schmelze enthaltene Dotierungsmittel in hinsichtlich der Dotierungswirkung überkompensierender Menge zugegeben wird,

und daß durch weitere Abscheidung aus der bisher verwendeten, nunmehr überkompensiert Zink-dotierten Schmelze der restliche p-leitende Bereich (5) des Halbleiterkörpers (1) abgeschieden wird, bis der Halbleiterkörper eine Gesamtdicke d zwischen 150 µm und 200 µm erreicht hat.

2. Verfahren nach Anspruch 1, <u>gekennzeichnet</u> dadurch, daß Zink aus der Gasphase der Schmelze zugeführt wird.

### Claims

1. A process for the production of a light-emitting diode having a semiconductor body which is provided with electrodes and which consists of doped gallium-aluminium arsenide which is in part n-conducting and in part p-conducting, where a constant gradient of the concentration of the aluminium content occurs in the semiconductor body and where this semiconductor body has been first deposited by means of liquid phase epitaxy on to a substrate body which is removed again during a final production step, <u>characterised in</u> that for a frequency of the luminescence radiation of the diode which can be set in advance,

- the deposition of a first n-conducting region (4) of the semiconductor body (1) takes place from a tellurium-, sulphur-, or selenium-doped melt which contains the gallium-aluminium arsenide to be deposited,

- that, on continuing deposition of the gallium-aluminium arsenide, when a $Ga_{1-x}Al_xAs$ mixed crystal composition is obtained which has an Al-content $\underline{x}$ and which has the band gap corresponding to the predetermined luminescence frequency, zinc is added as a new dopant to the melt in an amount which overcompensates for the dopant already contained in the melt as regards its doping action,

- and that by further deposition from the previously used melt, which is now doped with zinc to an over-compensated extent, the remaining p-conducting zone (5) of the semiconductor body (1) is deposited until the semiconductor body has reached an overall thickness $\underline{d}$ of between 150 μm and 200 μm.

2. A process as claimed in Claim 1, <u>characterised in</u> that zinc is supplied to the melt from the gas phase.

**Revendications**

1. Procédé pour fabriquer une diode à luminescence comportant un corps semiconducteur muni d'électrodes et constitué par un arseniure de gallium et d'aluminium dopé , conducteur du type n par endroits et conducteur du type p par endroits et dans lequel il existe un gradient continu de la teneur en aluminium, ce corps semiconducteur ayant été déposé,au moyen de l'épitaxie en phase liquide, tout d'abord sur un corps formant substrat que l'on élimine ensuite lors de l'étape finale du procédé de fabrication, caractérisé par le fait

- que pour une fréquence pouvant être prédéterminée, du rayonnement de luminescence de la diode, on réalise le dépôt d'une première région (4) conductrice du type n du corps semiconducteur (1) à partir d'une masse fondue dopée par du tellure, du soufre ou du sélénium et qui contient l'arseniure de gallium et d'aluminium devant être déposé,

- que moyennant la poursuite du dépôt de l'arseniure de gallium et d'aluminium, lorsque l'on atteint une composition de cristal mixte de $Ga_{1-x}Al_xAs$ contenant une teneur x en Al et possédant un intervalle d'énergie entre bandes correspondant à la fréquence de luminescence prédéterminée, on ajoute du zinc comme nouvelle substance dopante de la masse fondue, à l'agent de dopage déjà contenu dans la masse fondue, en une quantité réalisant une surcompensation de l'action de dopage, et

- qu'on dépose la région résiduelle (5) conductrice du type p du corps semiconducteur (1) au moyen d'un dépôt ultérieur à partir de la masse fondue utilisée jusqu'alors et dopée maintenant par du zinc avec une surcompensation, jusqu'à ce que le corps semiconducteur ait atteint une épaisseur globale d'comprise entre 150 μm et 200 μm.

2. Procédé suivant la revendication 1, caractérisé par le fait que le zinc est obtenu à partir de la phase gazeuse de la masse fondue.

0 068 416

FIG 1

FIG 2

1

# FIG 3